# EUROPEAN PATENT APPLICATION

(11) **EP 1 450 378 A2**
(43) Date of publication of application: **25.08.2004**
(21) Application number: 04003840.8
(22) Date of filing: 20.02.2004
(51) Int. Cl.: H01F 10/08, H01F 10/32, H05K 9/00, H01F 41/26

(54) **Soft magnetic member, method for manufacturing thereof and electromagnetic wave controlling sheet**

(30) Priority: 24.02.2003 JP 2003046595; 26.02.2003 JP 2003050167
(71) Applicant: TDK Corporation, Chuo-ku, Tokyo 103-8272 (JP)
(72) Inventor: Hashimoto, Yasuo, c/o TDK Corporation, Tokyo 103-8272 (JP); Wakayama, Katsuhiko, c/o TDK Corporation, Tokyo 103-8272 (JP); Kakinuma, Akira, c/o TDK Corporation, Tokyo 103-8272 (JP); Tasaki, Kazunori, c/o TDK Corporation, Tokyo 103-8272 (JP); Iijima, Yasushi, c/o TDK Corporation, Tokyo 103-8272 (JP); Chou, Tsutomu , c/o TDK Corporation, Tokyo 103-8272 (JP)
(74) Representative: HOFFMANN - EITLE

(57) **Abstract**

There is provided a soft magnetic member comprising a resin film 2, a metal sublayer 3 formed on the resin film 2 and a soft magnetic metal layer 4a formed on the metal sublayer 3. In the soft magnetic metal layer 4a, on the side of the metal sublayer 3, there is formed a region having a higher Fe concentration and a higher saturation flux density than other regions.

## Description

### BACKGROUND OF THE INVENTION

### Field of the Invention

The present invention relates to a soft magnetic member exhibiting high complex permeability in a high frequency band exceeding 800 MHz and a method of manufacturing the soft magnetic member. Also the present invention relates to an electromagnetic wave controlling sheet advantageously used in information and communications equipment.

### Description of the Related Art

Information and communications equipment tends to become smaller in size and the frequency band of radio waves used is shifting to the high frequency side. So far, high performance design of electronic parts utilizing permittivity has been carried out. On the other hand, in a case where efficiency is to be improved by utilizing electromagnetic waves in near-field,high performance design utilizing permeability can be expected. Because the permeability of magnetic materials in a high frequency band equal to 800 MHz or more shows much smaller values than the permeability in a band of lower frequency, permeability has not hitherto been utilized in a positive manner and dielectrics have been exclusively used in high frequency related parts. However, in high frequency related parts including antennas, limitations to the improvement of properties by using permittivity have appeared and it is difficult to expect dramatic improvements in efficiency.

On the other hand, research to improve permeability in high frequencies such as a giga Herz band (hereinafter referred to as a "GHz band") is also being pushed forward with.

For example, it is known that a multilayer film having a structure formed by alternately depositing a magnetic material layer and a nonmagnetic material layer (SiO₂) on a substrate by the ion beam sputtering shows excellent complex permeability in a GHz band (NTT R&D, Vol. 42, No. 5 (1993), pp. 689-696). In this case, in order to realize high permeability, the smaller magnetostriction, the more advantageous. For this reason, there has been proposed, for example, a magnetic material layer in which magnetostriction is controlled to low levels by causing Fe (magnetostriction: negative) and an NiFe alloy (magnetostriction: positive) to diffuse mutually. Also, a film of small magnetostriction, such as a CoNbZr film, is subjected to a heat treatment in a magnetic field, thereby imparting induction anisotropy to the film, so that high permeability is maintained even in a GHz band. Incidentally, anisotropy can be imparted also by forming a fine pattern in addition to performing a heat treatment in a magnetic field (the Journal of Japan Society for Applied Magnetics, Vol. 24 (2000), pp. 731-734).

In the above-described techniques for increasing permeability in a GHz band involve increasing an anisotropic magnetic field thereby shifting to a higher frequency side by depositing a soft magnetic film on a substrate and thereafter imparting induction anisotropy to the soft magnetic film by subjecting the film to a heat treatment in a magnetic field or imparting shape anisotropy by forming a fine pattern. However, in the above-described techniques, it is necessary to use a hard substrate material and furthermore in order to impart anisotropy, it is necessary to perform an expensive heat treatment and work. Therefore, shape and price restrictions are severe and form a bottleneck in practical application.

The present invention was made on the basis of such technical problems and aims to achieve high permeability in a high frequency band exceeding 800 MHz without the treatment of imparting induction anisotropy by performing a heat treatment in a magnetic field or without the treatment of imparting shape anisotropy by forming a fine pattern and furthermore aims to provide a soft magnetic member which does not require the use of a hard substrate material.

### SUMMARY OF THE INVENTION

The present invention provides a multilayer soft magnetic member including a soft magnetic metal layer and in which a magnetic coupling between the soft magnetic metal layer and other layers is improved. In the present invention, the first through to the third techniques which will be described below are proposed as techniques for improving a magnetic coupling between the soft magnetic metal layer and other layers.

More specifically, in the first technique, there are provided an insulating layer, a metal sublayer disposed opposite to the insulating layer, and a soft magnetic metal layer disposed on the metal sublayer, and a region having a higher saturation flux density than other regions is formed in the soft magnetic metal layer on the side of said metal sublayer (hereinafter may sometimes be referred to as a "region of high saturation flux density"). By providing such a region of high saturation flux density on the side of the metal sublayer, it is possible to strengthen a magnetic coupling between the soft magnetic metal layer and the metal sublayer.

Therefore, when the metal sublayer is constituted by a material having a larger anisotropic magnetic field than the soft magnetic metal, it is possible to enlarge the anisotropic magnetic field of the soft magnetic metal layer.

Because a resonance frequency has a relation which is proportional to the square root of an anisotropic magnetic field, by adopting the construction of the present invention it is possible to achieve high permeability in a high frequency band exceeding 800 MHz, and further in a GHz band. In order to enjoy this effect, it is desirable that other regions of the soft magnetic metal layer of the present invention be constituted by a material having higher permeability than the region of high saturation flux density.

In the soft magnetic member of the invention, it is preferred that the metal sublayer be a material having a higher coercive force than the soft magnetic metal layer.

In the soft magnetic member of the present invention, a unit comprising the insulating layer, the metal sublayer and the soft magnetic metal layer can be used singly. Or a plurality of such units can also be used by being laminated in multiple layers.

In the soft magnetic member of the present invention, a metal oxide layer may be interposed between the insulating layer and the metal sublayer.

Incidentally, there is an alloy including Fe as a typical exampleofasoftmagneticmetal. In this alloy, its saturation flux density varies according to the Fe concentration. Concretely, the higher the Fe concentration, the higher the saturation flux density. If the soft magnetic metal layer is constituted by an Fe-Ni alloy of a predetermined composition, then by providing an alloy region having a higher Fe concentration than the predetermined composition between the soft magnetic metal layer and the metal sublayer, it is possible to improve a magnetic coupling between the soft magnetic metal layer and the metal sublayer, because this region has a higher saturation flux density than the Fe-Ni alloy region of the predetermined composition.

Hence, in the second technique, there are provided a first region constituted by a resin material, a second region which is disposed opposite to the first region and constituted by an alloy containing Fe and manifesting soft magnetism, and a third region disposed between the first region and the second region and constituted by a metal having a larger anisotropic magnetic field than the second region. And at the same time, between the second region and the third region is further provided a fourth region having a higher Fe concentration than the second region. Because in the second technique a fourth region having a higher Fe concentration than the second region is provided between the second region and the third region, it is possible to increase a magnetic coupling between the fourth region and the third region. As a result of this, a magnetic coupling between the third region and the second region corresponding to the soft magnetic metal layer is also improved.

In the soft magnetic member of the present invention, the first region is constitutedby a resin material. Therefore, the soft magnetic member of the present invention has flexibility and is easily handled when it is installed in various types of equipment.

In the invention, the second region and the fourth region can be constituted by an alloy containing Ni and/or Co, and Fe. That is, the present invention includes a case where the fourth region exhibits soft magnetism. Even in this case, a higher Fe concentration in the fourth region than the second region is a precondition.

Although as described above, the second region and the fourth region can be constituted by an alloy containing Ni and/or Co, and Fe, the second region and the fourth region can also be constituted by an alloy having the same component elements. For example, when the second region and the fourth region are to be formed by electrolytic plating, by using the same plating bath and controlling plating conditions, it is possible to form the fourth region having a higher Fe concentration than the second region. At this time, the second region and the fourth region are constituted by an alloy having the same component elements. As described above, according to the present invention, it is possible to form the second region and the fourth region constituted by an alloy having the same component elements by performing electrolytic plating once. However, it is needless to say that the second region and the fourth region may be constituted by metals (alloys) having different component elements.

As will be described later, it is possible to ensure a mode in which the Fe concentration in the fourth region increases continuously toward the third region. By adopting this embodiment, the frequency properties of complex permeability can be controlled by controlling the value of an anisotropic magnetic field. Furthermore, corrosion resistance can be improved because the Fe concentration of the surface of a soft magnetic metal layer decreases relatively.

When in the soft magnetic member of the invention, an alloy containing Ni and/or Co, and Fe is adopted in the second region and the fourth region, the third region may be constituted by Ni or an Ni based alloy of a predetermined composition.

In the soft magnetic member of the present invention, a unit comprising the first region, the second region, the third region and the fourth region may be used singly or this unit may be used by being laminated in multiple layers.

In the third technique, by keeping the ratio between the thickness s of the metal sublayer and the thickness p of the soft magnetic metal layer (p/s) within a certain range, a magnetic coupling between the soft magnetic metal layer and the metal sublayer is increased. That is, in the present invention there is provided a soft magnetic member comprising an insulating layer, a metal sublayer disposed opposite to the insulating layer, and a soft magnetic metal layer disposed on the metal sublayer, and it is proposed that 5 ≤ p/s < 10 and 0 < s < 100 nm.

Also in this case, it is preferred that the metal sublayer be constituted by a material having a higher coercive force or a larger anisotropic magnetic field than soft magnetic metal layer.

In the soft magnetic member of the present invention, it is preferred that the soft magnetic metal layer be constituted by an alloy containing 20 to 80 wt % Fe, and Ni and/or Co.

Furthermore, the soft magnetic member of the present invention includes an embodiment in which a unit comprising an insulating layer, a metal sublayer and a soft magnetic metal layer is laminated in multiple layers.

Incidentally, it is also possible to use the third technique and the first technique in combination, whereby it is ensured that in the soft magnetic metal layer, on the side of the metal sublayer, there is formed a region having a higher saturation flux density than other regions, and it can be ensured that providing that the thickness of the metal sublayer is denoted by s and the thickness of the soft magnetic metal layer is denoted by p, then the relationships hold: 5 ≤ p/s ≤ 10 and 0 < s ≤ 100 nm.

The soft magnetic member of the present invention was described in detail above. By being installed in the interior of a cellular phone, for example, the soft magnetic member of the invention can contribute to an improvement of radiation efficiency of electromagnetic waves emitted to outside the cellular phone by its antenna. Therefore, the soft magnetic member of the present invention can be used as an electromagnetic wave controlling sheet. And this electromagnetic wave controlling sheet comprises a substrate having flexibility, a conductive metal layer supported by the substrate, and a soft magnetic metal layer which is supported by the conductive metal layer and comprises an Fe-Ni based alloy. In this electromagnetic wave controlling sheet, between the conductive metal layer and the soft magnetic metal layer is interposed a compound which improves a magnetic coupling between the conductive metal layer and the soft magnetic metal layer. The substrate has a thickness of 25 µm or less, the conductive metal layer has a thickness of 100 nm or less, and the soft magnetic metal layer has a thickness of 1 µm or less.

In the electromagnetic wave controlling sheet of the present invention, for example, Ni can be used in the conductive metal layer.

It is preferred that PET (polyethylene terephtalate) or PBT (polybutylene terephtalate) be used as the substrate.

The soft magnetic metal member of the present invention, in which a magnetic coupling between the soft magnet metal layer and other layers is improved, can be advantageously manufactured by the following manufacturing method. More specifically, the soft magnetic metal member of the present invention can be manufactured by a manufacturing method, which comprises a step (a) for forming a conductive metal film on a resin film and a step (b) for forming a soft magnetic metal film containing Fe on the conductive metal film by electrolytic plating. In the step (b), a region is formed on the side of an interface with said conductive metal film in the soft magnetic metal film, and the Fe concentration of the region is higher than the average Fe concentration of the soft magnetic metal film.

In this step (b), by performing electrolytic plating under conditions set so that the Fe concentration of the soft magnetic metal film decreases continuously with increasing distance from the interface with the conductive metal film, it is possible to form a region having higher Fe concentration than the average Fe concentration of the soft magnetic metal film on the side of an interface with the conductive metal film in the soft magnetic metal film. For example, this can be accomplished by performing electrolytic plating under such conditions that the stirring conditions during electrolytic plating are continuously changed or the current density is continuously changed.

Soft magnetic members which can be advantageously used in a high frequency band exceeding 800 MHz were described above. The soft magnetic member of the present invention can also be used in a frequency band of 800 MHz or lower, for example, in the vicinity of 100 MHz. In this case, it is necessary only that if the thickness of the metal sublayer is denoted by s and the thickness of the soft magnetic metal layer is denoted by p, then the relationships hold: 4 ≤ p/s ≤ 15 and 100 < s ≤ 1000 nm.

### BRIEF DESCRIPTION OF THE DRAWINGS

FIG. 1 is a partial sectional view showing a soft magnetic member in an embodiment of the present invention;
FIG. 2 is a partial sectional view showing an example of the construction of a soft magnetic metal layer which constitutes the soft magnetic member shown in FIG. 1;
FIG. 3 is a partial sectional view showing another example of the construction of a soft magnetic metal layer which constitutes the soft magnetic member shown in FIG. 1;
FIG. 4 is a partial sectional view showing another example of the construction of a soft magnetic metal layer which constitutes the soft magnetic member shown in FIG. 1;
FIG. 5 is a graph showing the distance from the interface between a soft magnetic metal layer and a metal sublayer and the Fe concentration in the soft magnetic metal layer;
FIG. 6 a partial sectional view showing the construction of a laminated soft magnetic member obtained by laminating the soft material member shown in FIG. 1 in multiple layers;
FIG. 7A to FIG. 7C are each a view showing a method of manufacturing the laminated soft magnetic member shown in FIG. 6; FIG. 7A is a view showing a condition in which a metal sublayer is formed on a resin film; FIG. 7B is a view showing a condition in which a soft magnetic metal layer is formed on a metal sublayer; FIG. 7C is a view showing how a soft magnetic member is laminated, with a resin film and a soft magnetic metal layer opposed to each other;

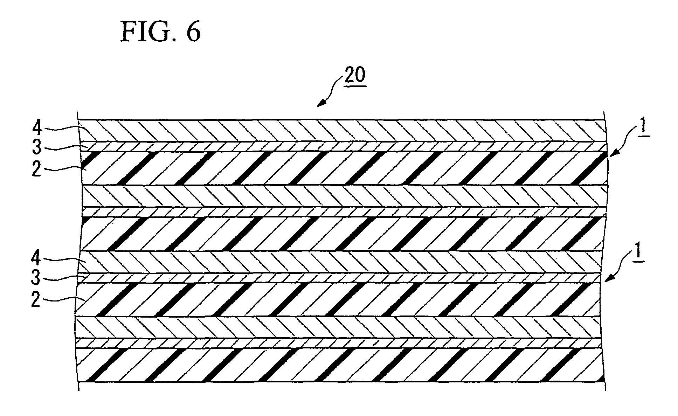

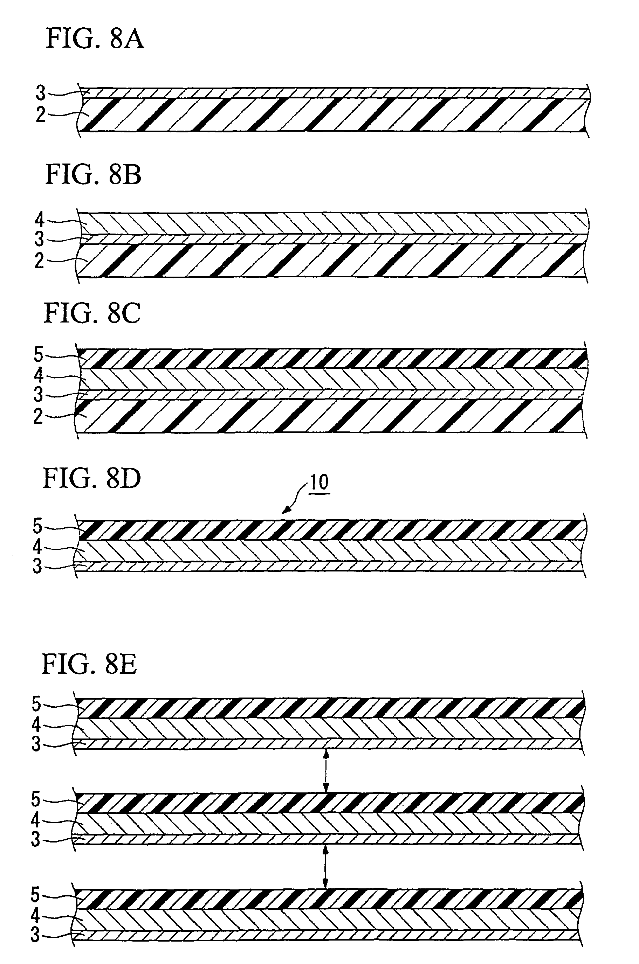

FIG. 8A to FIG. 8E are each a view showing another method of manufacturing the laminated soft magnetic member shown in FIG. 6; FIG. 8A is a view showing a condition in which a metal sublayer is formed on a resin film; FIG. 8B is a view showing a condition in which a soft magnetic metal layer is formed on a metal sublayer; FIG. 8C is a view showing a condition in which a resin layer is formed on a soft magnetic metal layer; FIG. 8D is a view showing a soft magnetic member in which a metal sublayer, a soft magnetic metal layer and a resin layer are laminated; FIG. 8E is a view showing how a soft magnetic member is laminated, with a resin layer and a metal sublayer opposed to each other;
FIG. 9 is a graph showing the relationship between the distance of an Fe-Ni alloy from the interface with a metal sublayer and Fe concentration in soft magnetic members produced under the conditions a to c in Example 1;
FIG. 10 is a graph showing the frequency properties of an imaginary part (µ") of the complex permeability of soft magneticmembers produced under the conditions a to c in Example 1;
FIG. 11 is a table showing the construction of the samples a to h obtained in Example 2;
FIG. 12 is a graph showing the measurement result of the complex permeability of the sample a in Example 2;
FIG. 13 is a graph showing the measurement result of the complex permeability of the sample b in Example 2;
FIG. 14 is a graph showing the measurement result of the complex permeability of the sample c in Example 2;
FIG. 15 is a graph showing the measurement result of the complex permeability of the sample d in Example 2;
FIG. 16 is a graph showing the measurement result of the complex permeability of the sample e in Example 2;
FIG. 17 is a graph showing the measurement result of the complex permeability of the sample f in Example 2;
FIG. 18 is a graph showing the measurement result of the complex permeability of the sample g in Example 2;
FIG. 19 is a graph showing the measurement result of the complex permeability of the sample h in Example 2;
FIG. 20 is a graph showing the B-H curve of the sample a in Example 2;
FIG. 21 is a graph showing the B-H curve of the sample b in Example 2;
FIG. 22 is a graph showing the B-H curve of the sample c in Example 2;
FIG. 23 is a graph showing the B-H curve of the sample d in Example 2;
FIG. 24 is a graph showing the B-H curve of the sample e in Example 2;
FIG. 25 is a graph showing the B-H curve of the sample g in Example 2;
FIG. 26 is a graph showing the B-H curve of a sample deposited a 19 nm thick Ni film; and
FIG. 27 is a graph showing the B-H curve of a sample deposited a 37 nm thick Ni film.

### DETAILED DESCRIPTION OF THE PREFERRED EMBODIMENTS

Embodiments of the present invention will be described below.

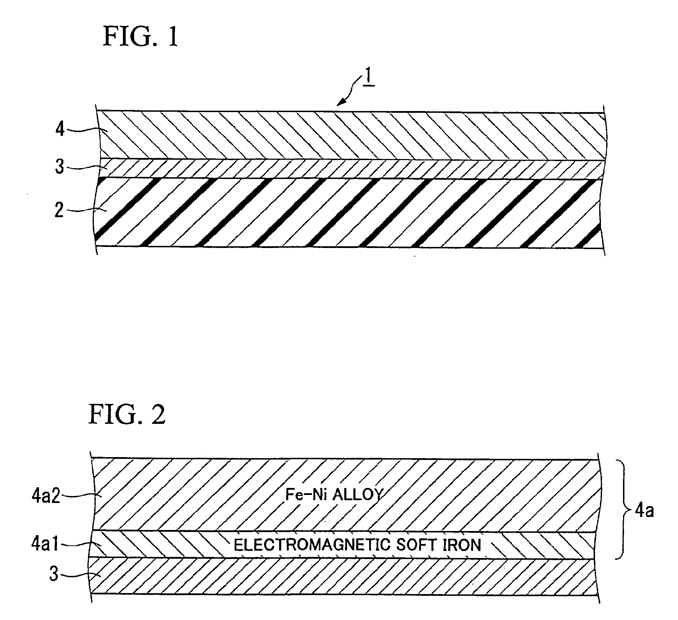

FIG. 1 is a partial sectional view showing a soft magnetic member in an embodiment of the present invention.

A soft magnetic member (an electromagnetic wave controlling sheet) 1 shown in FIG. 1 is constituted by a resin film 2, a metal sublayer 3 formed on the resin film 2 and a soft magnetic metal layer 4 formed on the metal sublayer 3. FIG. 2 to FIG. 5 are each a partial sectional view showing examples of construction of a soft magnetic metal layer constituting the soft magnetic member.

As the resin film 2 which functions as an insulating layer, Polyethylene, polypropylene, polystyrene, melamine resin, urea resin, phenol resin, polyethylene terephthalate, polybutylene terephthalate, polysulfone, polycarbonate, polytetrafluorethylene, polyamide-imide, polyamide, polyolefin, polyimide, PPS (polyphenylenesulfide), fluoroplastics and silicone resin can be used. Among these, it is desirable to use resin materials having heat resistance when a heat treatment is performed in the manufacturing process of a laminated soft magnetic member, as will be described later.

The soft magnetic metal layer 4 can be constituted by any of the transition metal elements exhibiting soft magnetism or any of the alloys of transition metal elements and other metal elements. As concrete examples, such alloys are those which contain, as a main component, at least one element selected from the group consisting of Fe, Ni and Co, and they are Fe-Ni based alloys, Fe-Co based alloys, Fe-Ni-Co based alloys and Co-Ni based alloys. Among these alloys, it is desirable to use alloys having a saturation flux density of 1.0 T or greater and, preferably, of 1.5 T or greater. Among these, it is especially desirable to use Fe-Ni based alloys, Fe-Co based alloys and Fe-Ni-Co based alloys having an Fe content of 20 to 80 wt % (preferably, 30 to 70 wt %, more preferably, 40 to 65 wt %). Alloys having such a composition are high in saturation flux density, and are advantageous in that the resonance frequency is shifted to the higher frequency side by increasing the anisotropic magnetic field through anisotropy control. These alloys can contain 15 at% or less of one or more of Nb, Mo, Ta, W, Zr, Mn, Ti, Cr, Cu and Co. Incidentally, when a soft magnetic metal layer 4 is formed by plating (electrolytic plating or non-electrolytic plating), such elements as C and S are inevitably contained, and the soft magnetic metal layer 4 of the present invention allows the presence of such elements contained.

As for the soft magnetic metal layer 4, either a crystalline alloy or an amorphous alloy can be used. As an amorphous alloy, Co based alloys and Fe based alloys can be used. Additionally, the present invention allows the use of Fe based microcrystalline alloys. A microcrystalline alloy is generally known as an alloy which is mainly composed of fine crystals of about 10 nm in grain size.

The soft magnetic metal layer 4 can be produced by a variety of film formation processes including the plating, vacuum evaporation method, sputtering and the like. These film formation processes can be applied each alone. Accordingly, the soft magnetic metal layer 4 can be formed either solely by plating or solely by evaporation. Needless to say, a plurality of film formation processes can be combined. Plating is preferable for the present invention in that plating can form films at lower temperatures than the vacuum evaporation method. This is because in the present invention, the soft magnetic metal layer 4 is formed on a resin film 2, and hence it is preferable that no thermal effect is given to the resin film 2. Additionally, plating has a merit that plating can obtain a prescribed thickness of film in a shorter period of time as compared to the sputtering method. Incidentally, when the soft magnetic metal layer 4 is obtained by plating, some elements such as S contained in the plating bath are mixed in the soft magnetic metal layer 4, and hence the soft magnetic metal layer 4 formed by plating is discriminable from the soft magnetic metal layers 4 formed by the other processes.

For the metal sublayer 3, it is desirable to select a material having a higher coercive force (anisotropic magnetic field) than the soft magnetic metal layer 4. By doing so, it is possible to increase the anisotropic magnetic field of the soft magnetic metal layer 4, thereby to increase the ferromagnetic resonance frequency in a GHz band. As a result, it is possible to increase the µ' (real part of complex permeability) in the vicinity of 2 GHz and simultaneously to reduce µ" (imaginary part of complex permeability). In the frequency bands used in portable communications equipment, the larger µ' and the smaller µ" , the higher an effect on the radiation efficiency improvement of electromagnetic waves will be. Incidentally, an effect on the permeability improvement in a GHz band can also be expected by forming a layer composed of a material similar to that of the metal sublayer 3 on the soft magnetic metal layer 4. When the soft magnetic metal layer 4 is an Fe-Ni alloy, it is desirable to use Ni as the metal sublayer 3.

Although the metal sublayer 3 serves to enhance the anisotropic magnetic field of the soft magnetic metal layer 4, the metal sublayer 3 also plays a role of a conductive layer becoming necessary when the soft magnetic metal layer 4 is formed by electrolytic plating on the resin film 2. The metal sublayer 3 can be formed, for example, by the vacuum evaporation method, the sputtering or non-electrolytic plating.

Next, the thickness of the soft magnetic member 1 will be described.

The thickness of the resin film 2 should be 50 µm or less. Although the resin film 2 functions as a substrate of the soft magnetic member 1, the resin film 2 also carries out the function of mutual insulation of the soft magnetic metal layers 4 when the soft magnetic member 1 is laminated. However, if this insulating layer becomes thick, the packing density of the soft magnetic metal layer 4 decreases and hence the permeability of the soft magnetic member 1 decreases. Therefore, the thickness of the resin film 2 should be 50 µm or less. The preferable thickness of the resin film 2 is 25 µm or less and the more preferable thickness of the resin film 2 is 10 µm or less. As a matter of course, it is difficult to manufacture an extremely thin resin film 2 and, at the same time, it is impossible for an extremely thin resin film 2 to have a predetermined strength necessary for forming the soft magnetic metal layer 4. Therefore, it is recommended that the thickness be 0. 2 µm or more, or 2 µm or more. Incidentally, because the resin film 2 used in the present invention has flexibility, handling is easy when the soft magnetic member 1 including this resin film 2 is installed in various types of equipment.

It is preferred that the soft magnetic metal layer 4 be 1 µm or less in thickness. Incidentally, the thickness of the soft magnetic metal layer 4 is hereinafter denoted by p. This is because in thicknesses with p exceeding 1 µm, eddy current losses are large in a high frequency band exceeding 800 MHz which is a target of the present invention and hence the function as a magnetic material deteriorates. Therefore, the thickness p is more preferably 0.5 µm or less. Because it is desirable that the soft magnetic metal layer 4 be densely formed, it is necessary that the soft magnetic metal layer 4 has a minimum film thickness of such an extent that enables a dense film to be formed by various processes. Incidentally, an oxide film may be formed on the surface of the soft magnetic metal layer 4.

In order to ensure that the metal sublayer 3 functions to improve the anisotropic magnetic field of the soft magnetic metal layer 4 and also functions as a conductive layer during electrolytic plating, the thickness of the metal sublayer 3 should be 100 nm or less when the metal sublayer 3 is used in a high frequency band exceeding 800 MHz. Incidentally, the thickness of the metal sublayer 3 is hereinafter denoted by s. A preferable film thickness s for a use in a high frequency band exceeding 800 MHz is 80 nm or less, and a more preferable film thickness s is 50 nm or less.

Incidentally, between the metal sublayer 3 and the resin film 2, for example, a metal oxide layer or an adhesive layer may be interposed. Also, on the surface of the metal sublayer 3, i.e., between the metal sublayer 3 and the soft magnetic metal layer 4, a metal oxide layer may be present. The interposition of a metal oxide layer which is large in electric resistance weakens the magnetic coupling between the metal sublayer 3 and the soft magnetic metal layer 4 a little, but increases the electric resistance along the film cross section direction and provides an effect which reduces the eddy current. If the thickness of the metal oxide layer is too large, plating becomes difficult. Therefore, the thickness of the metal oxide layer should be 40 nm or less and is preferably 20 nm or less, more preferably 10 nm or less.
This metal oxide layer can be formed by exposing the metal sublayer 3 to the air after completion of the metal sublayer 3 formation. This is also the case for the oxide film formed on the surface of the soft magnetic metal layer 4.

The soft magnetic member 1 of the present invention is characterized by that a region rich in Fe (an Fe-rich region) is provided on the side of the metal sublayer 3 of the soft magnetic metal layer 4.

FIG. 2 shows an example of the construction of a soft magnetic metal layer 4a. The soft magnetic metal layer 4a shown in FIG. 2 is constituted by an electromagnetic soft iron layer 4a1 and an Fe-Ni alloy layer 4a2 and the electromagnetic soft iron layer 4a1 is disposed on the side of the metal sublayer 3. Because the electromagnetic soft iron layer 4a1 has a higher Fe concentration than the Fe-Ni alloy layer 4a2, it follows that in the soft magnetic metal layer 4a shown in FIG. 2, an Fe-rich region is provided on the side facing the metal sublayer 3. Furthermore, because electromagnetic soft iron (saturation flux density: 2 T, permeability: 200) has a higher saturation flux density than an Fe-Ni alloy (for example, in the case of a composition of a 19 wt % Fe-81 wt % Ni alloy, saturation flux density: 1 T, permeability: 2500), in the soft magnetic metal layer 4a shown in FIG. 2, a region having a higher saturation flux density than other regions is provided on the side facing the metal sublayer 3.

In the present invention, an Fe-rich region, i.e., a region having a higher saturation flux density than other regions is provided on the side facing the metal sublayer 3. As a result of this, for example, when the metal sublayer 3 is constituted by Ni of large anisotropic magnetic field, the magnetic coupling between the metal sublayer 3 and the soft magnetic metal layer 4 (4a) becomes strong and it becomes possible to control µ' in a wider band or peak values of µ" in higher frequencies.

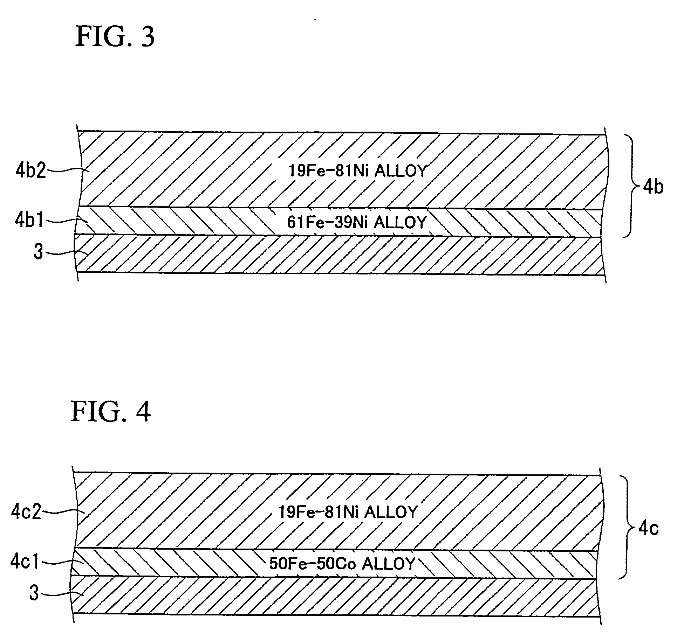

FIG. 3 shows another example of the construction of a soft magnetic metal layer 4b. The soft magnetic metal layer 4b shown in FIG. 3 is constituted by a 61 wt % Fe-39 wt % Ni alloy layer 4b1 and a 19 wt % Fe-81 wt % Ni alloy layer 4b2, both soft magnetic metal layers having the same component elements, and the 61 wt % Fe-39 Ni wt % alloy layer 4b1 is provided on the side of the metal sublayer 3. Because the 61 wt % Fe-39 wt % Ni alloy has a higher Fe content than the 19 wt % Fe-81 wt % Ni alloy, it follows that also in the soft magnetic metal layer 4b shown in FIG. 3, an Fe-rich region is provided on the side facing the metal sublayer 3. Also, the 61 wt % Fe-39 wt % Ni alloy (saturation flux density: 1.6 T, permeability: 1500) has a higher saturation flux density than the 19 wt % Fe-81 wt % Ni alloy (saturation flux density: 1 T, permeability: 2500) , it follows that in the soft magnetic metal layer 4b shown in FIG. 3, a region having a higher saturation flux density than other regions is provided on the side facing the metal sublayer 3.

FIG. 4 shows another example of the construction of a soft magnetic metal layer 4c. The soft magnetic metal layer 4c is constituted by a 50 wt % Fe-50 Co wt % alloy (what is called Permendur) layer 4c1 and a 19 wt % Fe-81 Ni wt % alloy layer 4c2, and the 50 wt % Fe-50 wt % Co wt % alloy layer 4c1 is provided on the side of the metal sublayer 3. Because the 50 wt % Fe-50 wt % Co wt % alloy layer 4c1 has a higher Fe content than the 19 wt % Fe-81 wt % Ni alloy layer 4c2, it follows that also in the soft magnetic metal layer 4c shown in FIG. 4, an Fe-rich region is provided on the side facing the metal sublayer 3. Also, the 50 wt % Fe-50 wt % Co alloy (saturation flux density: 2.4 T, permeability: 1000) has a higher saturation flux density than the 19 wt % Fe-81 wt % Ni alloy (saturation flux density: 1 T, permeability: 2500), in the soft magnetic metal layer 4c shown in FIG. 4, a region having a higher saturation flux density than other regions is provided on the side facing the metal sublayer 3.

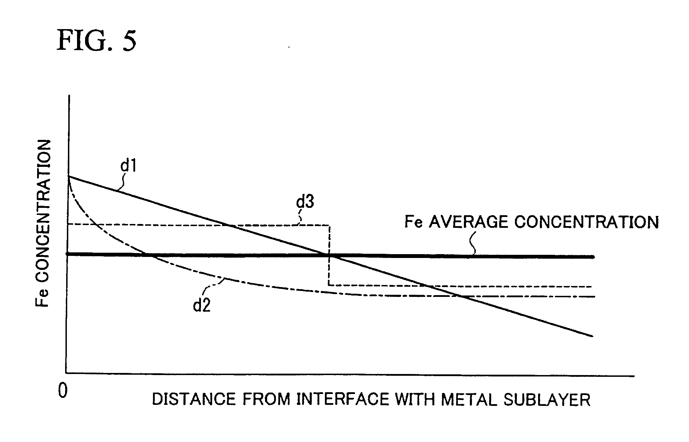

FIG. 5 is a drawing showing another example of the construction of the soft magnetic metal layer 4 and a graph showing the distance from the interface between the soft magnetic metal layer 4 and the metal sublayer 3 and the Fe concentration in the soft magnetic metal layer 4. In the examples shown in FIG. 2 to FIG. 4, the soft magnetic metal layers 4a, 4b, 4c are each constituted by two metal (alloy) layer having different compositions. However, in the example shown in FIG. 5, a soft magnetic layer 4d is constituted by a basically single soft magnetic alloy and an Fe-rich region is formed in this layer. Incidentally, FIG. 5 is a graph in which the distance from the interface between the soft magnetic metal layer 4d and the metal sublayer 3 is plotted on the abscissa and the Fe concentration in the soft magnetic metal layer 4d is plotted on the ordinate.

In FIG. 5, the thick solid line indicates the average concentration of Fe. In FIG. 5, the thin solid line (d1) indicates the Fe concentration in the soft magnetic metal layer 4d. As shown in FIG. 5, in the soft magnetic metal layer 4d the Fe concentration is highest at the interface with the metal sublayer 3 and decreases continuously with increasing distance from this interface. Therefore, it follows that also in the soft magnetic metal layer 4d, an Fe-rich region is provided on the side facing the metal sublayer 3. In the Fe-Ni alloy, in which the higher the Fe concentration, the higher the saturation flux density, a region having a higher saturation flux density than other regions is provided on the side facing the metal sublayer 3. Incidentally, as indicated by the alternate long and short dash line (d2), the Fe concentration maybe such that the Fe concentration is highest at the interface with the metal sublayer 3 and decreases continuously with increasing distance from this interface, but it becomes almost constant from a certain position. Furthermore, as indicated by the dotted line (d3) of FIG. 5, the Fe concentration may be such that the Fe concentration shows an almost constant value from the interface with the metal sublayer 3 to a predetermined position and follows by a constant value a little lower than the above-described almost constant value after this predetermined position.

As described above, the present invention includes a mode in which the Fe concentration changes intermittently (hereinafter sometimes referred to as "a first mode") and a embodiment in which the Fe concentration changes continuously (hereinafter sometimes referred to as "a second mode").

When the first mode adopted, by using combinations of various metals and alloys, such as a combination of an Fe-Ni alloy and an Fe-Co alloy and a combination of an Fe-Ni alloy and an Fe-Ni-Co alloy as in the above-described soft magnetic metal layers 4a, 4b, 4c, it is possible to provide a region rich in Fe (an Fe-rich region) on the side of the metal sublayer 3 of the soft magnetic metal layer 4.

When the second mode is adopted, by using the substantially same alloy as in the soft magnetic metal layer 4d, it is possible to provide a region rich in Fe (an Fe-rich region) on the side of the metal sublayer 3 of the soft magnetic metal layer 4.

Furthermore, as a third mode, by keeping the ratio between the thickness s of the metal sublayer and the thickness p of the soft magnetic metal layer 4 (p/s) with a certain range, it is also possible to increase a magnetic coupling between the soft magnetic metal layer and the metal sublayer. When this mode is adopted, "p/s" should be in the range of 5 ≤ p/s < 10.

The thickness s of the metal sublayer 3 and the thickness p of the soft magnetic metal layer 4 were described above, respectively. By keeping the ratio between s and p (p/s) in the range recommended by the present invention, it is possible to increase a magnetic coupling between the soft magnetic metal layer 4 and the metal sublayer 3. More specifically, if p/s is too small, the frequency properties of the imaginary part of complex permeability (µ") becomes broad or shows double peak and tan δ (= µ"/µ', µ': the real part of complex permeability) becomes large. This is undesirable. On the other hand, if p/s is too large, the frequency properties of µ" shows a single peak and the band also becomes narrow. However, the frequency at which µ' begins to attenuate decreases and the permeability in a GHz band deteriorates. Although p/s depends on the thickness and material quality of the soft magnetic metal layer 4 and metal sublayer 3, the range of p/s should be 5 ≤ p/s < 10 and is preferably 6 ≤ p/s < 8.

The first mode, the second mode and the third mode were described in detail above. Needless to say, it is possible to use the first mode and the third mode in combination and the second mode and the third mode in combination.

In the soft magnetic member 1 shown in FIG. 1, the metal sublayer 3 and the soft magnetic metal layer 4 are formed on one side of the resin film 2. In the present invention, it is also possible to form the metal sublayer 3 and the soft magnetic metal layer 4 on both front and back sides of the resin film 2.

Although FIG. 1 shows an example in which the resin film 2 is used as an insulating layer, the present invention does not exclude the use of materials other than the resin film 2. For example, ceramics materials can also be used as an insulating layer.

In the present invention, the soft magnetic member 1 can be used singly and it is also possible to use a plurality of laminated soft magnetic members 1. A member in which the soft magnet member 1 is laminated in multiple layers is hereinafter referred to as a laminated soft magnetic member 20.

FIG. 6 is a partial sectional view showing an example of a laminated soft magnetic member 20 according to this embodiment. As shown in FIG. 6, the laminated soft magnetic member 20 has a sectional structure in which a resin film 2, a metal sublayer 3 and a soft magnetic metal layer 4 are alternately laminated. It is important that the thickness of the whole laminated soft magnetic member 20 be 0.2 mm or less. This is because when the laminated soft magnetic member 20 in sheet form is applied to a cellular phone, it is necessary that the laminated soft magnetic member 20 adapt to the size of the cellular phone. A more preferable thickness is 0.15 mm or less and a still more preferable thickness is 0.1 mm or less. Incidentally, the laminated soft magnetic member 20 may include a portion in which the lamination order of a unit comprising the resin film 2, the metal sublayer 3 and the soft magnetic metal layer 4 differs.

By laminating the soft magnetic member 1 shown in FIG. 1, the laminated soft magnetic member 20 shown in FIG. 6 can be obtained.

Because the resin film 2 of the soft magnetic member 1 constitutes an insulating layer, the thickness of the insulating layer becomes 50 µm or less. As a matter of course, in some cases the insulating layer becomes thicker than that of the resin film 2 when an adhesive is interposed between layers in laminating the soft magnetic member 1. Therefore, when an adhesive is used, it is necessary to determine the thickness of the resin film 2 so that the thickness of the insulating layer becomes 50 µm or less. If an adhesive is formed from a resin at this time, it follows that also the adhesive layer constitutes the insulating layer. Incidentally, it is possible to provide an insulating layer on the soft magnetic metal layer 4 which is positioned at the uppermost layer, so that the soft magnetic metal layer 4 is not exposed to the outside.

Additionally, a sticking agent or a double coated adhesive tape can be applied to either of the surfaces of the laminated soft magnetic member 20. This is for the sake of convenience in the application of the laminated soft magnetic member 20 to appliances such as cellular phones.

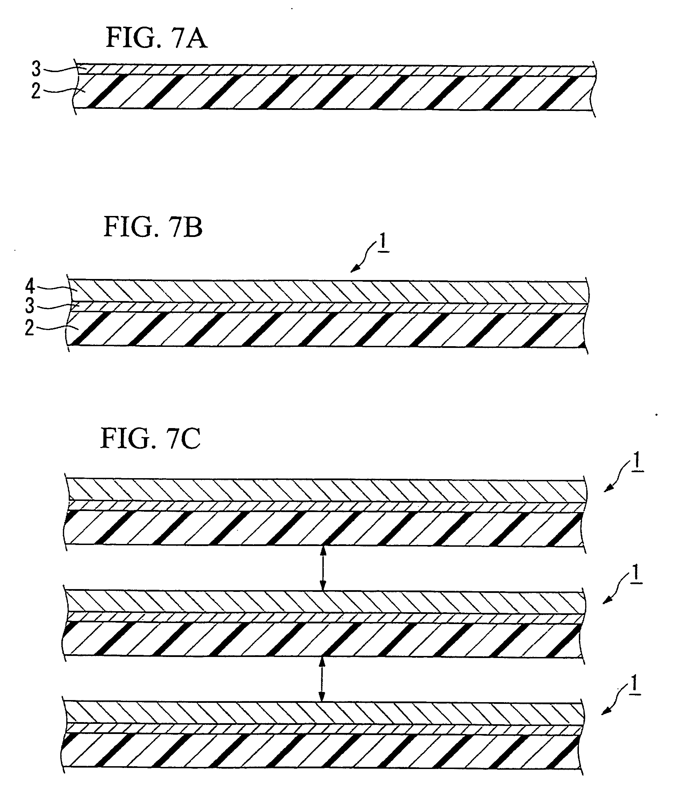

A preferred manufacturing method for obtaining the laminated soft magnetic member 20 will be described below on the basis of FIG. 7A to FIG. 7C.

First, a metal sublayer 3 is formed on a resin film 2 by the vacuum evaporation method, for example (FIG. 7A).

By forming a soft magnetic metal layer 4 on the metal sublayer 3 by electrolytic plating, for example, after the formation of the metal sublayer 3, it is possible to obtain the soft magnetic member 1 shown in FIG. 1 (FIG. 7B).

A prescribed number of the soft magnetic members 1 are produced, the members are laminated in such a way that the resin films 2 and the soft magnetic metal layers 4 of the respective soft magnetic members 1 are made to face each other, and thus the laminated soft magnetic member 20 shown in FIG. 6 can be obtained (FIG. 7C).

The bonding of the soft magnetic members 1 together can be performed by disposing an adhesive of epoxy resin, silicone resin, etc., for example, between the soft magnetic members 1. The viscosity of an adhesive should be 1000 cP or lower and is preferably 300 cP or lower, more preferably 200 cP or lower. An adhesive to which a solvent has been added is applied to the soft magnetic member 1, the solvent is then caused to evaporate to such an extent that the adhesive maintains adhesion properties, and thereafter the soft magnetic members 1 are laminated. Due to the static electricity of the resin film 2 which composes the soft magnetic member 1, it is also possible to maintain the laminated condition without using an adhesive. In this case, after the soft magnetic members 1 have been laminated, only the outer peripheral portion thereof can be subjected to adhesive bonding for the purpose of improving the adhesion strength by immersing the laminated members into an adhesive. Furthermore, because an adhesive layer functions as an insulating layer, laminating may be performed, with the soft magnetic metal layers 4 opposed to each other or with the resin films 2 opposed to each other.

By performing stress relief annealing after obtaining the laminated soft magnetic member 20, it is also possible to improve the magnetic properties. For example, when an adhesive is used in bonding the soft magnetic members 1 together, a stress relief annealing can also be performed in such a manner as to serve as a heat treatment for drying the adhesive. When a stress relief annealing is performed, it is desirable to use for the resin film2 polyamide-imide resin, polyamide resin, polyimide resin or PPS (polyphenylenesulfide) since they are excellent in heat resistance.

Furthermore, when PET (polyethylene terephthalate) or PBT (polybuthylene terephthalate) is used for the resin film 2, it is also possible to improve the magnetic properties of the soft magnetic member 1 and laminated soft magnetic member 20 by imparting induction anisotropy to the metal sublayer 3 by use of contraction stresses by heating.

Additionally, the laminated soft magnetic member 20 can be processed into a desired shape by the warm press processing. Furthermore, the laminated soft magnetic member 20 can be processed by cutting into a desired size.

Next, another manufacturing method for obtaining the laminated soft magnetic member 20 will be described on the basis of FIG. 8A to FIG. 8D.

First, a metal sublayer 3 is formed on a resin film 2 by the vacuum evaporation method, for example (FIG. 8A). A soft magnetic metal layer 4 is formed on the metal sublayer 3 by electrolytic plating, for example, after the formation of the metal sublayer 3 (FIG. 8B). These steps are the same as in the manufacturing method shown in FIG. 7A and FIG. 7B.

Next, a resin layer 5 for heat fusion bonding is formed on the soft magnetic metal layer 4 (FIG. 8C). The formation of the resin layer 5 can be performed by various techniques of coating, spraying, etc.

By peeling and removing the resin film 2 after the formation of the resin layer 5, a soft magnetic member 10 in which the metal sublayer 3, the soft magnetic metal layer 4 and the resin layer 5 are laminated is obtained (FIG. 8D). The peeling of the resin film 2 can be relatively easily performed by making the adhesive strength of the resin layer 5 with respect to the soft magnetic metal layer 4 higher than the adhesive strength of the resin film 2 with respect to the metal sublayer 3.

A prescribed number of the soft magnetic members 10 are produced, the members are laminated in such a way that the resin layers 5 and the soft magnetic metal layers 4 of the respective soft magneticmembers 10 are made to face each other, and thus the laminated soft magnetic member 20 can be obtained (FIG. 8E).

Bonding the soft magnetic members 10 together can be performed by use of the resin layers 5. That is, laminating is performed, with the resin layers 5 and the soft magnetic metal layers 4 facing each other, and thereafter the resin layers 5 are fused and cured by a prescribed heat treatment, which can ensure the mutual adhesion strength between the adjacent soft magnetic members 10. Additionally, although FIG. 8A to FIG. 8E show an example in which the plurality of the soft magnetic members 10 are produced and then laminated, needless to say it is also possible to obtain a winding body in such a way that the peeling off of the resin film 2 and the formation of the resin layer 5 are conducted consecutively, and the sheet body is subjected to winding.

Incidentally, although in the above description the soft magnetic members 10 are bonded through heat fusion bonding of the resin layers 5, the soft magnetic members 10 can be bonded through thermo-compression of the resin layers 5. For instance, the soft magnetic members 10 can be mutually bonded with the aid of the thermo-compression bonded resin layers 5, on the basis of the selection of PET for the resin layer 5 and the application of a prescribed pressure under the condition of being heated to a temperature of about 150 to 300°C.

Furthermore, the mutual bonding of the soft magnetic members 1 in the present invention can also be performed by use of an adhesive as described on the basis of FIG. 8A to FIG. 8E. In this case, the heating during bonding is unnecessary.

Although the above descriptions were given on the assumption that the soft magnetic member 1 (10) of the present invention is used in a high frequency band exceeding 800 MHz, the soft magnetic member 1 (10) of the present invention can also be used in a frequency band of 800 MHz or lower, for example, in the vicinity of 100 MHz. In this case, however, the thickness of the metal sublayer 3 should exceed 100 nm. This is because the magnetic coupling with the soft magnetic metal layer 4 becomes weak if the thickness of the metal sublayer 3 is 100 nm or less. However, if the thickness exceeds 1000 nm, the thickness is too large and the superiority as the soft magnetic member 1 (10) is lost. Therefore, on the assumption that the soft magnetic member 1 (10) is used in the above-described frequency band, the thickness (s) of the metal sublayer 3 should be 100 nm to 1000 nm (not including 100 nm) . A preferable thickness s is 110 nm to 700 nm and a more preferable thickness s is 110 nm to 500 nm.

When the thickness (s) of the metal sublayer 3 is in the above-described range, the magnetic effect on the soft magnetic metal layer 4 of the metal sublayer 3 thickness on the soft magnetic metal layer 4 becomes small. However, if p/s is less than 4, the control effect of the metal sublayer 3 on an anisotropic magnetic field becomes small and high permeability cannot be obtained. If p/s exceeds 15, a decrease in permeability due to an eddy current become remarkable because the film thickness becomes large. Therefore, p/s should be 4 to 15. Excellent complex permeability can be obtained in this range.

### (Embodiments)

Next, the present invention will be described in further detail by referring to concrete embodiments.

### <Example 1>

An experiment which was conducted to confirm the relationship between electrolytic plating conditions and the Fe concentration in plated layers is described as Example 1.

An Ni film was formed on a 13 µm PET film, which is an insulating layer, in a thickness of 19 nm as the metal sublayer by the evaporation method and was then opened to the air. Subsequently, a soft magnetic member was produced as the soft magnetic metal layer by the electrolytic plating an Fe-Ni alloy containing 61 wt % Fe (composition of the plating solution bath). The electrolytic plating was performed by use of the following plating solution under the following three conditions, and the distance between a stirrer for stirring and the plating film was about 20 nm. The thickness of the each plating film was 200 nm. The ratio p/s was 10.53.

| Name of chemical | Chemical formula | Solution composition (g/l) |
|---|---|---|
| Nickel sulfate hexahydrate | NiSO₄·6H₂O | 150-450 |
| | | |
| Nickel chloride hexahydrate | NiCl₂·6H₂O | 15-45 |
| | | |
| Boric acid | H₃BO₃ | 10-40 |
| | | |
| Ferrous sulfate heptahydrate heptahydrate | FeSO₄·7H₂O | 1-20 |
| | | |
| Glazing agent | - | 0.1-2 |

Condition a: Current density···0.8 A/dm², weak stirring···(5 rpm)
Condition b: Current density···0.8 A/dm², strong stirring···(50 rpm)
Condition c: Current density···Switchover between 0.8 A/dm² and 0.5 A/dm², strong stirring···(50 rpm)

When the section of a soft magnetic member obtained under the condition a was observed with a TEM (transmission electron microscope), it became apparent that the Fe-Ni alloy (soft magnetic metal layer) is constituted by fine crystals having a grain size of about 30 nm.

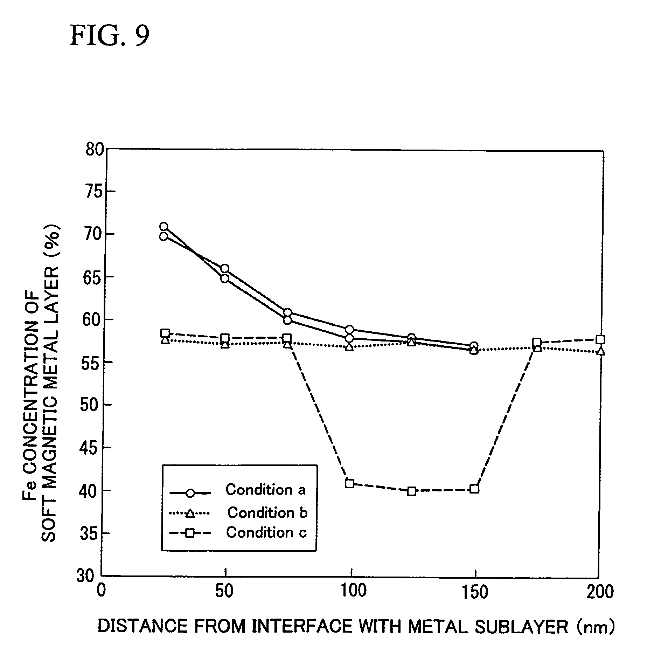

FIG. 9 shows the relationship between the distance from the interface with the Ni deposited layer (metal sublayer) and the Fe concentration in the Fe-Ni alloy plated layer obtained under the conditions a to c. Incidentally, a composition analysis was performed by electron diffraction. In the Fe-Ni alloy plated layer under the condition a, the closer to the interface with the Ni deposited layer, the higher the Fe concentration. However, the Fe concentration decreases with increasing distance from the interface with the Ni deposited layer, and the Fe concentration tends to become constant when the distance from the interface with the Ni deposited layer is about 100 nm or more. Compared to 61 wt %-Ni, which is the average composition of an Fe-Ni alloy film, the Fe concentration is high in the range of about 100 nm or less from the interface with the Ni deposited layer. In this manner, it is apparent that under the condition a, an Fe-rich region is formed on the side of the metal sublayer. The saturation flux density is higher in this Fe-rich region than other regions. A soft magnetic member obtained under the condition a belongs to a embodiment in which the Fe concentration changes continuously, i.e., the above-described second embodiment.

In contrast, in an Fe-Ni alloy plated layer obtained under the condition under which stirring was more strongly than under the condition a, scarcely any change was observed in the Fe concentration.

In an Fe-Ni alloy plated layer obtained under the condition c which involves a current density switchover, the Fe concentration is high when the current density was set to 0.8 A/dm² and the Fe concentration is low when the current density is 0.5 A/dm². Under the condition c, an Fe-rich region is formed on the side of the metal sublayer because the current density of 0.8 A/dm² is used first. Also a soft magnetic member obtained under the condition c belongs an embodiment in which the Fe concentration changes continuously, i.e., the above-described second embodiment.

Incidentally, in this embodiment, a composition analysis was performed by electron diffraction. For this reason, the analysis result of the interface between the metal sublayer and the soft magnetic metal layer was a value including the Ni of the metal sublayer and, therefore, this value was excluded from FIG. 9.

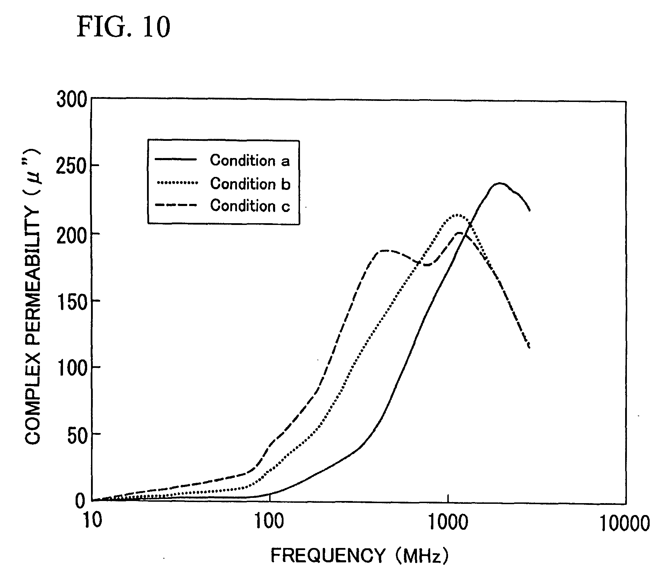

FIG. 10 shows the frequency properties of an imaginary part (µ") of the complex permeability of soft magnetic members produced under the conditions a to c. The more the peak value of µ" on the high frequency side, the higher the resonance frequency. As is apparent from FIG. 10, in the soft magnetic member obtained under the condition a, the peak value of µ" is on a higher frequency side than the soft magnetic members obtained under the conditions b and c. It might be thought that this is because in the soft magnetic member obtained under the condition a, a region having a high saturation flux density is formed because the area near the interface with the metal sublayer in the soft magnetic metal layer is rich in Fe, with the result that the magnetic coupling with the metal sublayer (Ni) having larger magnetic anisotropy than the Fe-Ni alloy has become strong. In the soft magnetic member obtained under the condition c, there are two peaks of µ" and it is apparent that a widened band of µ" has been achieved.

Incidentally, although Example 1 was described above in a case where the soft magnetic member is singly used, a similar effect can be obtained even with a laminated soft magnetic member in which the soft magnetic member is laminated in multiple layers. Although in the above example an Fe-rich region was formed near the interface with the metal sublayer of the soft magnetic metal layer by selecting stirring conditions during electrolytic plating, it is also possible to obtain an Fe concentration distribution similar to that under the condition a of FIG. 9 by controlling the current density during electrolytic plating, concretely, by lowering the current density. Furthermore, although the case where the Fe concentration changes continuously was shown in the above example, needless to say, the embodiment in which the Fe concentration changes intermittently, i.e., the first embodiment may be adopted as shown in FIG. 2 and FIG. 3.

### <Example 2>

An experiment which was conducted to confirm a change in frequency properties when the ratio between the thickness s of the metal sublayer and the thickness p of the soft magnetic metal layer (p/s) is varied is shown as Example 2. In Example 2, the third mode is examined although the second mode was examined in Example 1.

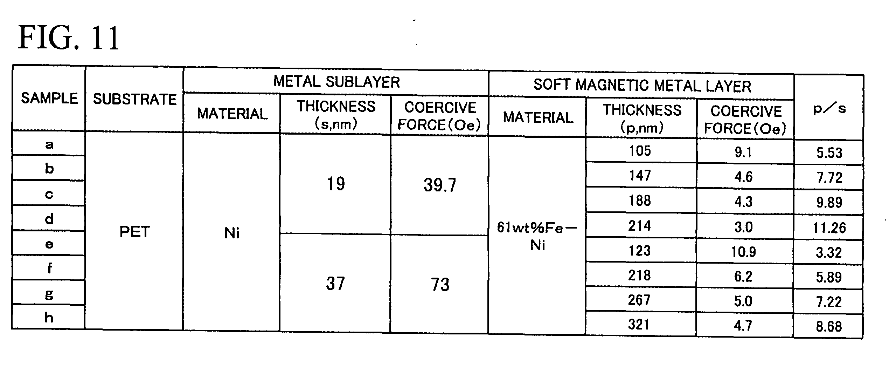

PET substrates were prepared. An Ni base film (a metal sublayer) 19 nm and 37 nm in thickness was formed on each of the PET substrates by the oblique incident evaporation method. After that, Fe-Ni alloy films (soft magnetic metal layers) of various thicknesses which contain about 61 wt % Fe were formed with the Ni base film serving as a cathode conductor and eight types of soft magnetic members were produced as the samples a to h shown in FIG. 11.

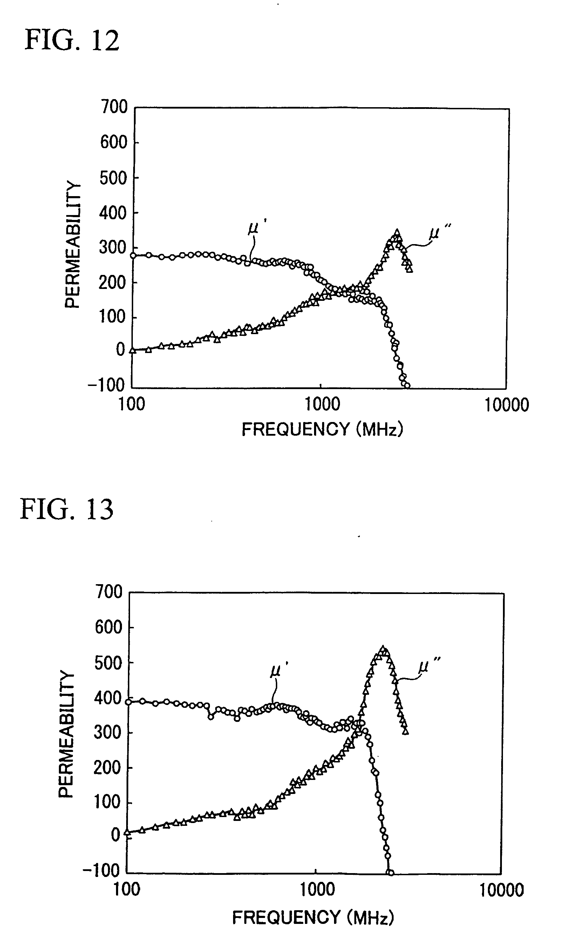

The complex permeability of the obtained eight types of soft magnetic members was measured by use of high frequency permeability measuring instrument made by Ryowa Electronics, Co. (PMF 3000). The measurement results are shown in FIG. 12 to FIG. 19.

First, the samples a to d whose thickness (s) of the Ni base film is 19 nm will be described. As shown in FIG. 12, in the sample a (p/s = 5.53), high permeability of 150 or so is obtained at 2 GHz although the real part (µ') of complex permeability begins to attenuate in the vicinity of 800 MHz. The sample a has the thinnest film thickness among all of the samples a to d and it is apparent the attenuation of permeability which occurs in the vicinity of 800 MHz is not caused by an eddy current.

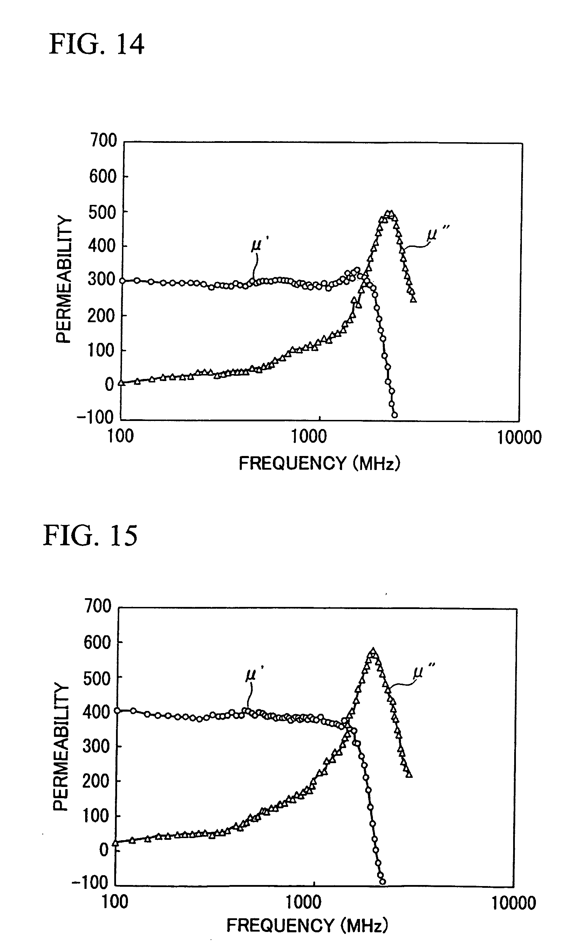

As shown in FIG. 13, in the samples b (p/s=7.72) because the attenuation of µ' begins at a frequency of 100 MHz (1 GHz) or lower and there is no increase in µ" in the vicinity of this frequency. As a result, tan δ is also suppressed. The sample c (FIG. 14, p/s = 9.89) and the sample d (FIG. 15, p/s = 11.26) also show a similar tendency. However, the resonance frequency of the sample c exceeds 2 GHz, whereas the resonance frequency of the sample d is less than 2 GHz.

Also as shown in FIG. 12 to FIG. 15, the frequency dependence of µ" shows a sharp shape with an increase in p/s. At the same time, because the frequency at which a peak value is reached decreases, complex permeability decreases also in a case where the Fe-Ni alloy film is too thick.

In this manner, when a 19 nm thick base film is used, goodproperties of large µ' and small tan δ (=µ" /µ') is exhibited when p/s is 5 to 10 (less than 10), particularly in the range of 6 to 8.

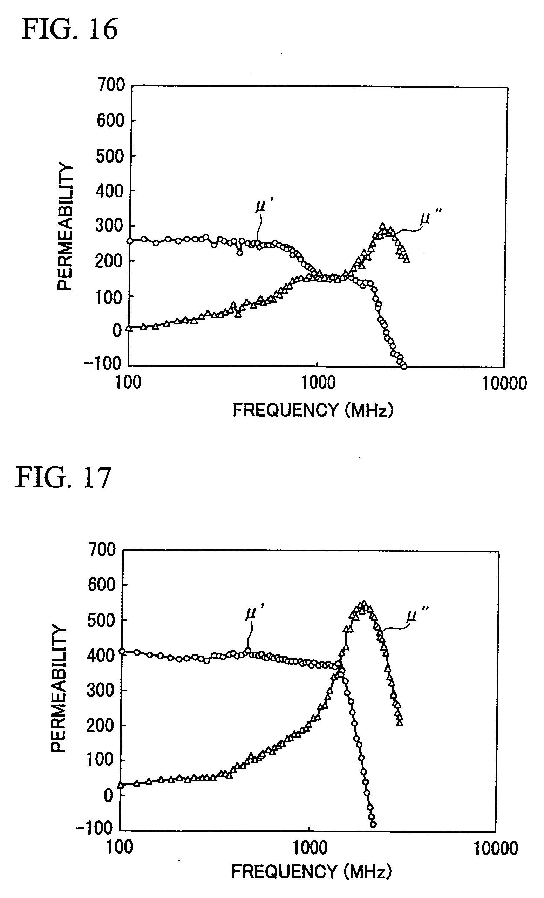

As shown in FIG. 16, although the sample e (p/s = 3.32) shows a high resonance frequency exceeding 2 GHz, µ' begins to attenuate in the vicinity of 650 MHz and µ" increases at the same time. Therefore, tan δ increases and this is undesirable.

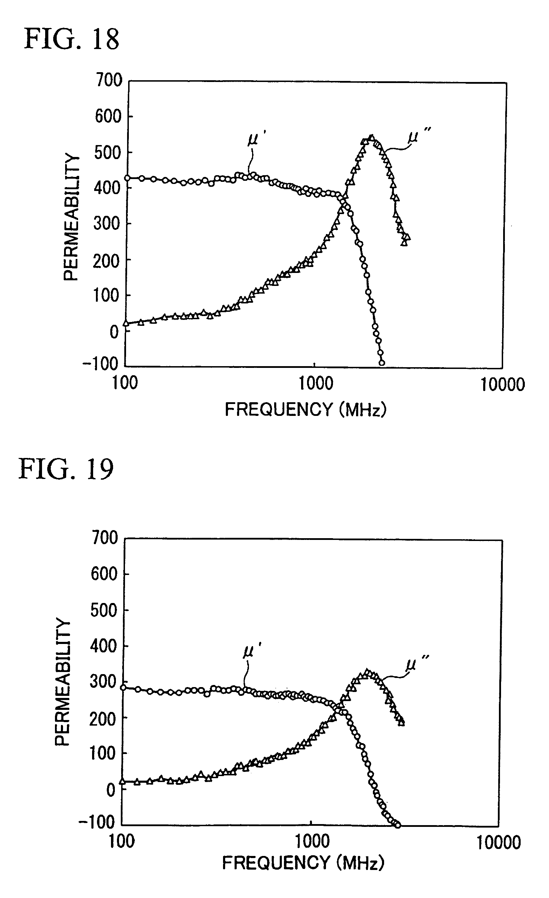

As shown in FIG. 17 and FIG. 18, the resonance frequency of the samples f (p/s = 5.89) and g (p/s = 7.22) decreases somewhat in comparison with the sample e, the value of µ" on the low frequency side decreases and tan δ is improved.

As shown in FIG. 19, sufficient and necessary properties are obtained in the sample h (p/s = 8.68) although the attenuating frequency decreases somewhat.

From the foregoing, when a 37 nm thick Ni base film is used, good properties of large µ' and small tan δ (= µ" /µ' ) is exhibited when p/s is in the range of 4 to 8.

Incidentally, the same applies also to the case where the thickness of the Ni base film is 19 nm. From FIG. 16 to FIG. 19, however, it is apparent that when the thickness of the Fe-Ni alloy film becomes large, the effect of the Ni base film decreases and the attenuating frequency of µ' decreases.

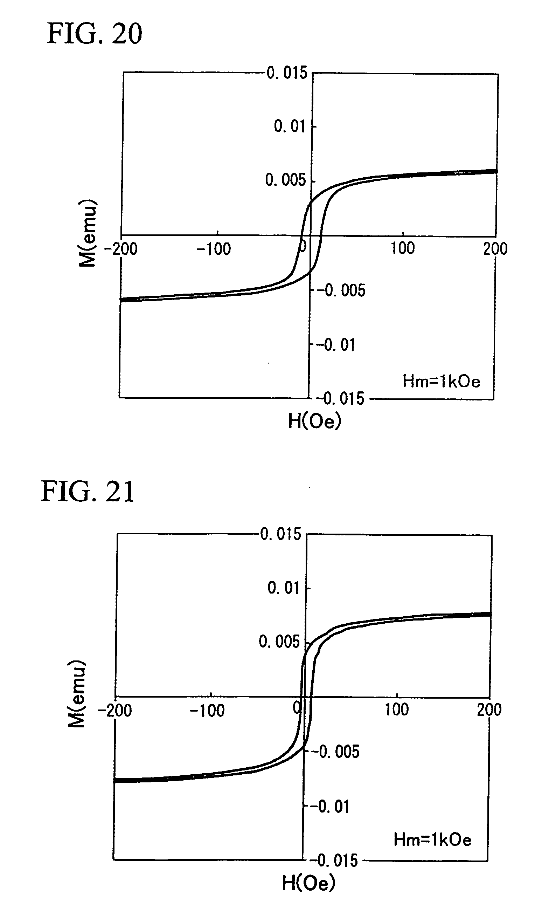

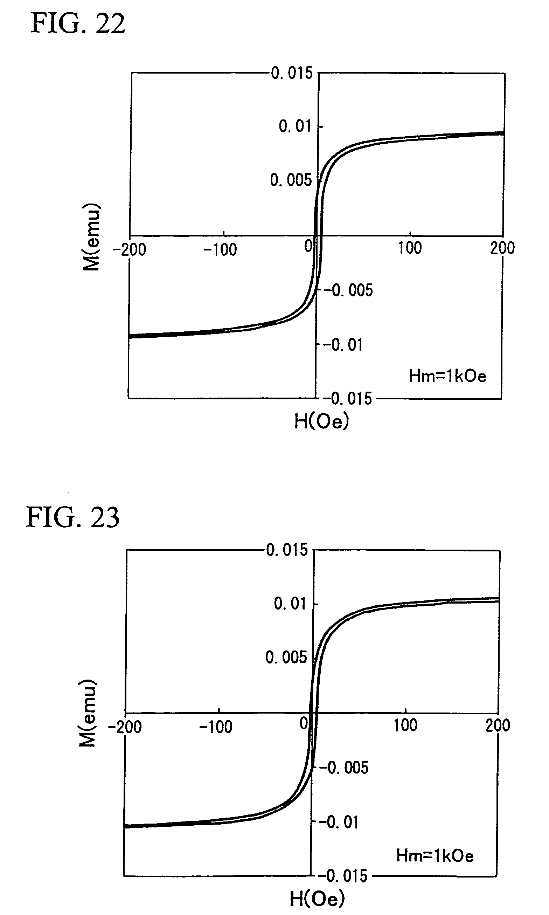

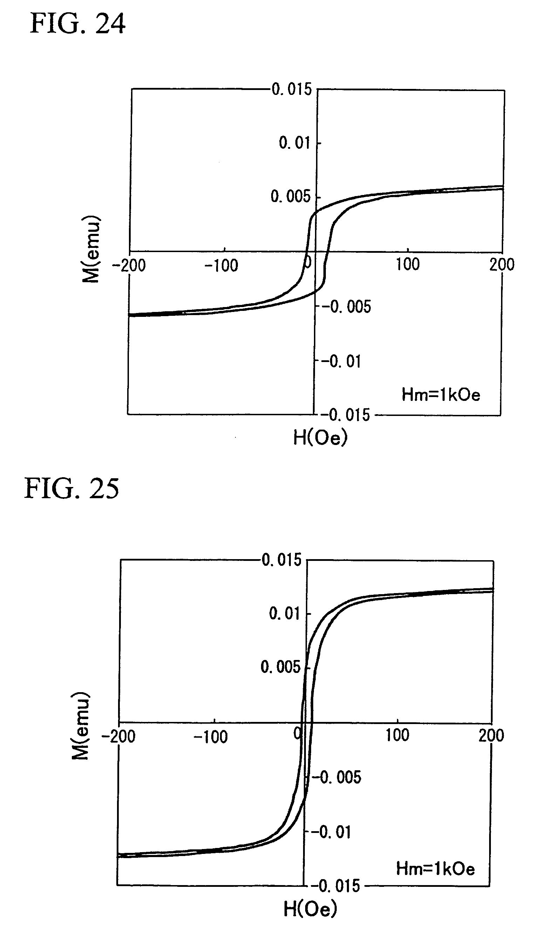

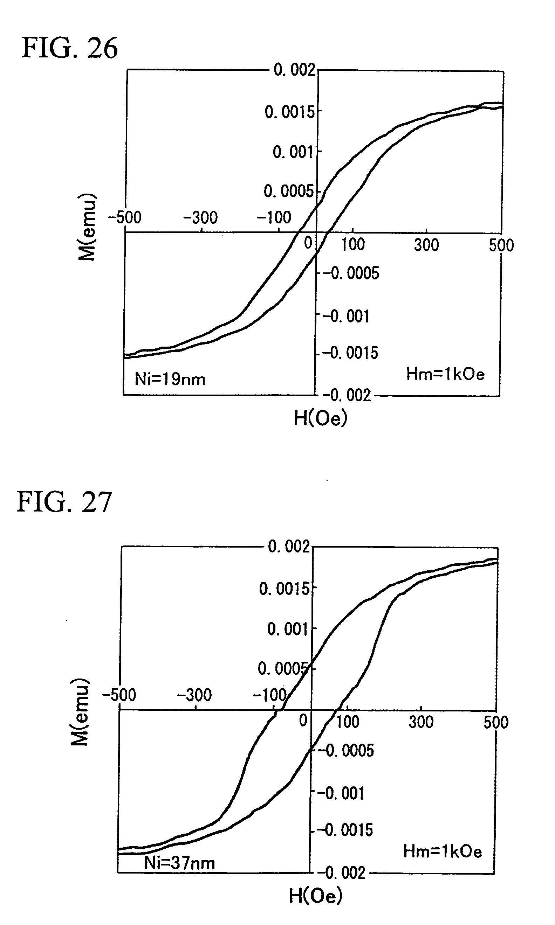

Next, for the samples a, b, c, d, e and g, the B-H curve was determined by a VSM (vibration sample magnetometer). The results are shown in FIG. 20 to FIG. 25. Incidentally, for samples in which only a Ni base film is formed on a substrate, the B-H curve was also determined. The results are shown in FIG. 26 (film thickness: 19 nm) and FIG. 27 (film thickness: 37 nm).

FIG. 20 to FIG. 23 each show the B-H curve of the samples a to d. The coercive force of the samples a to d is 10.2 Oe, 5.1 Oe, 3.2 Oe and 2.9 Oe, respectively. Incidentally, the coercive force is 39.7 Oe when a 19 nm thick Ni base film is singly used. The p/s dependence of the size of an anisotropic magnetic field also shows a tendency similar to that of coercive force, and it is apparent that the smaller the thickness of the Fe-Ni alloy film, the more susceptible the soft magnetic member will be to the effect of the Ni base film.

### <Example 3>

Soft magnetic members were produced by the same method as with Example 1, with the exception that the plated film thickness was controlled to 150 µm. The above-described condition a was adopted as the electrolytic plating condition. p/s was 7.89.

For soft magnetic members thus obtained, their complex permeability was measured. Incidentally, the same complex permeability measuring conditions as with Example 1 were adopted. As a result, high permeability of about 120 was obtained. This value is 300 % larger than the value obtained in the soft magnetic member obtained under the condition a in Example 1.

From the foregoing, it could be ascertained that higher permeability is obtained by making an Fe-rich region in the vicinity of the interface with the metal sublayer of the soft magnetic metal layer and keeping p/s within the range recommended by the present invention.

### <Example 4>

A 4 µm thick polyimide sheet was sputtered with Co in a thickness of 150 nm and an about 2 µm thick 60 wt % Fe-Ni alloy film was formed on this Co film. The ratio p/s was 13.3. The permeability of this soft magnetic member at 100 MHz was 50% higher than that of a rolled material (PB Permalloy) of the same thickness.

According to the present invention, it is possible to achieve high permeability in a GHz band and to obtain a soft magnetic member which does not require the use of a hard substrate material without imparting induction anisotropy by performing a heat treatment in a magnetic field or without imparting shape anisotropy by forming a fine pattern.

## Claims

1. A soft magnetic member, comprising:
an insulating layer;
a metal sublayer disposed opposite to said insulating layer; and
a soft magnetic metal layer disposed on said metal sublayer,
wherein a region having a higher saturation flux density than other regions is formed in said soft magnetic metal layer on the side of said metal sublayer.

2. A soft magnetic member according to claim 1, wherein said metal sublayer is constituted by a material having a larger anisotropic magnetic field than said soft magnetic metal layer.

3. A soft magnetic member according to claim 1, wherein said other regions are constituted by a material having higher permeability than said region of high saturation flux density.

4. A soft magnetic member according to claim 1, wherein a unit comprising said insulating layer, said metal sublayer and said soft magnetic metal layer is laminated in multiple layers.

5. A soft magnetic member according to claim 1, wherein a metal oxide layer is interposed between said insulating layer and said metal sublayer.

6. A soft magnetic member, comprising:
a first region constituted by a resin material;
a second region which is disposed opposite to said first region and constituted by an alloy containing Fe and manifesting soft magnetism;
a third region disposed between said first region and said second region and constituted by a metal having a larger anisotropic magnetic field than said second region; and
a fourth region which is disposed between said second region and said third region and has a higher Fe concentration than said second region.

7. A soft magnetic member according to claim 6, wherein said second region and said fourth region are constituted by an alloy containing Ni and/or Co, and Fe.

8. A soft magnetic member according to claim 7, wherein said second region and said fourth region are constituted by an alloy having the same component elements.

9. A soft magnetic member according to claim 8, wherein an Fe concentration in said fourth region increases continuously toward said third region.

10. A soft magnetic member according to claim 7, wherein said third region is constituted by Ni or an Ni based alloy.

11. A soft magnetic member according to claim 6, wherein a unit comprising said first region, said second region, said third region and said fourth region is laminated in multiple layers.

12. An electromagnetic wave controlling sheet, comprising:
a substrate having flexibility;
a conductive metal layer supported by said substrate; and
a soft magnetic metal layer which is supported by said conductive metal layer and is constituted by an Fe-Ni based alloy,
wherein between said conductive metal layer and said soft magnetic metal layer, is interposed a compound which improves a magnetic coupling between said conductive metal layer and said soft magnetic metal layer,
said substrate having a thickness of 25 µm or less, said conductive metal layer having a thickness of 100 nm or less, and said soft magnetic metal layer having a thickness of 1 µm or less.

13. An electromagnetic wave controlling sheet according to claim 12, wherein said conductive metal layer is constituted by Ni.

14. An electromagnetic wave controlling sheet according to claim 12, wherein said substrate is constituted by PET (polyethylene terephtalate) or PBT (polybutylene terephtalate).

15. A method of manufacturing a soft magnetic member, comprising:
a step (a) for forming a conductive metal film on a resin film; and
a step (b) for forming a soft magnetic metal film containing Fe on said conductive metal film by electrolytic plating,
wherein in said step (b), a region is formed on the side of an interface with said conductive metal film in said soft magnetic metal film, and the Fe concentration of said region is higher than the average Fe concentration of said soft magnetic metal film.

16. Amethod of manufacturing a soft magnetic member according to claim 15, wherein said step (b) is performed under conditions set so that the Fe concentration of said soft magnetic metal film decreases continuously, with increasing distance from the interface with said conductive metal film.

17. A soft magnetic member, comprising:
an insulating layer;
a metal sublayer disposed opposite to said insulating layer; and
a soft magnetic metal layer disposed on said metal sublayer,
wherein providing that the thickness of said metal sublayer is denoted by s and the thickness of said soft magnetic metal layer is denoted by p, then the relationships hold: 5 ≤ p/s < 10 and 0 < s < 100 nm.

18. A soft magnetic member according to claim 17, wherein saidmetal sublayer is constituted by amaterial having a higher coercive force or a larger anisotropic magnetic field than said soft magnetic metal layer.

19. A soft magnetic member according to claim 17, wherein said soft magnetic metal layer is constituted by an alloy containing 20 to 80 wt % Fe, and Ni and/or Co.

20. A soft magnetic member according to claim 17, wherein a unit comprising said insulating layer, said metal sublayer and said soft magnetic metal layer is laminated in multiple layers.

21. A soft magnetic member, comprising:
an insulating layer;
a metal sublayer disposed opposite to said insulating layer; and
a soft magnetic metal layer disposed on said metal sublayer,
wherein a region having a higher saturation flux density than other regions is formed in said soft magnetic metal layer on the side of said metal sublayer,
and providing that the thickness of said metal sublayer is denoted by s and the thickness of said soft magnetic metal layer is denoted by p, then the relationships hold: 5 ≤ p/s < 10 and 0 < s < 100 nm.

22. A soft magnetic member, comprising:
an insulating layer;
a metal sublayer disposed opposite to said insulating layer; and
a soft magnetic metal layer disposed on said metal sublayer,
wherein providing that the thickness of said metal sublayer is denoted by s and the thickness of said soft magnetic metal layer is denoted by p, then the relationships hold: 4 ≤ p/s ≤ 15 and 100 nm < s ≤ 1000 nm.
